Europäisches Patentamt

European Patent Office

Office européen des brevets

(11) Numéro de publication: **0 199 093**
**A1**

# (12) DEMANDE DE BREVET EUROPEEN

(21) Numéro de dépôt: **86103771.1**

(22) Date de dépôt: **20.03.86**

(51) Int. Cl.⁴: **C 30 B 15/30**

(30) Priorité: **25.03.85 FR 8504407**

(43) Date de publication de la demande:
**29.10.86 Bulletin 86/44**

(84) Etats contractants désignés:
**AT BE CH DE FR GB IT LI LU NL SE**

(71) Demandeur: **COMPAGNIE GENERALE D'ELECTRICITE**
**Société anonyme dite:**
**54, rue La Boétie**
**F-75382 Paris Cedex 08(FR)**

(71) Demandeur: **SOCIETE NATIONALE ELF AQUITAINE**
**Société anonyme dite**
**Tour Elf 2, Place de la Coupole La Défense 6**
**F-92400 Courbevoie(FR)**

(72) Inventeur: **Belouet, Christian**
**138 rue Houdan**
**F-92330 Sceaux(FR)**

(74) Mandataire: **Weinmiller, Jürgen et al,**
**Lennéstrasse 9**
**D-8133 Feldafing(DE)**

(54) **Procédé et dispositif pour tirer un ruban constitué par un support revêtu d'une couche d'un matériau semi-conducteur à partir d'un bain liquide de ce matériau.**

(57) Le procédé consiste à serrer les bords du ruban entre les deux mâchoires d'une pince et à déplacer la pince verticalement de bas en haut. Le dispositif comporte deux colonnes verticales (10, 11) sur lesquelles peuvent coulisser deux chariots (12, 13) portant chacun une pince (14, 15) et des moyens (16, 17, 19, 20) pour commander la manoeuvre des pinces et le déplacement des chariots le long des colonnes.
Application à réalisation de photopiles solaires.

EP 0 199 093 A1

./...

FIG.1

Procédé et dispositif pour tirer un ruban constitué par un support revêtu
d'une couche d'un matériau semi-conducteur à partir d'un bain liquide de
ce matériau

La présente invention concerne un procédé et un dispositif pour
tirer un ruban constitué par un support revêtu d'une couche d'un matériau
semi-conducteur à partir d'un bain liquide de ce matériau.

Un procédé et un dispositif de ce type sont illustrés par le
document FR-A-2.386.359. Sur la figure 2 de ce document, un ruban de
carbone 4 traverse un bain de silicium 2, après passage à travers une
fente 7 ménagée dans le fond d'un récipient 1 contenant le bain. Le
ruban 4 est tendu et tiré verticalement en continu par friction entre
deux rouleaux. Les deux rouleaux 5 situés en dessus du bain peuvent être
par exemple entraînés en rotation autour de leurs axes, en sens inverse
l'un de l'autre.

Le procédé de tirage illustré par ce document présente des inconvénients. En effet la pression exercée par les rouleaux sur le ruban peut
provoquer des fractures de la couche de silicium déposée. De plus, il est
difficile d'éviter que le ruban ainsi tiré ne se déplace dans son plan de
part et d'autre de l'axe de tirage, ce qui provoque des déchirures du
ruban sur les bords de la fente.

La présente invention a pour but de pallier ces inconvénients.

La présente invention a pour objet un procédé pour tirer un ruban
constitué par un support revêtu d'une couche d'un matériau semi-conduc-.
teur à partir d'un bain liquide de ce matériau, le ruban étant tendu dans
un plan vertical, caractérisé en ce qu'il comporte
- un serrage, entre les deux mâchoires d'une pince, de deux portions
opposées des deux bords respectifs du ruban, le serrage étant effectué à
un premier niveau au-dessus du bain de façon à saisir dans le plan
vertical le ruban revêtu de ladite couche
- et un déplacement vertical de la pince serrant le ruban, ce déplacement
s'effectuant à une vitesse constante prédéterminée, du premier niveau à
un deuxième niveau supérieur au premier niveau, la distance entre les
premier et deuxième niveaux étant grande par rapport à la longueur desdites portions.

Avantageusement, ladite pince étant une première pince, le procédé comporte en outre

- un serrage entre les deux mâchoires d'une deuxième pince analogue à la première pince, de deux portions opposées des deux bords respectifs du ruban, ce serrage étant effectué au premier niveau un peu avant la fin du déplacement de la première pince,

- un déplacement vertical de la deuxième pince serrant le ruban, ce déplacement s'effectuant du premier niveau au deuxième niveau dès que le serrage de la deuxième pince est réalisé, à une vitesse égale à ladite vitesse constante prédéterminée,

- une ouverture des mâchoires de la première pince lorsqu'elle atteint le deuxième niveau, de façon à lâcher le ruban

- et, juste après l'ouverture des mâchoires, un déplacement vertical de la première pince du deuxième niveau au premier niveau, ce déplacement s'effectuant à une vitesse supérieure à ladite vitesse constante prédéterminée, de manière que la première pince soit prête à saisir le ruban au premier niveau avant que la deuxième pince ne soit arrivée au deuxième niveau.

La présente invention a aussi pour objet un dispositif pour tirer un ruban constitué par un support revêtu d'une couche d'un matériau semi-conducteur à partir d'un bain liquide de ce matériau, le ruban étant tendu dans un plan vertical, caractérisé en ce qu'il comporte

- deux colonnes verticales disposées de part et d'autre des faces planes du ruban,

- un chariot fixé sur chaque colonne de façon à pouvoir être déplacé verticalement le long de la colonne,

- une pince fixée sur chaque chariot, cette pince comprenant deux mâchoires articulées pour saisir le ruban par ses bords, ces mâchoires étant munies de rainures dans lesquelles viennent se loger les bords du ruban,

- des moyens pour commander l'ouverture et la fermeture des mâchoires desdites pinces

- et des moyens pour commander le déplacement des chariots au-dessus du bain le long des colonnes.

Une forme particulière d'exécution de l'objet de la présente invention est décrite ci-dessous, à titre d'exemple, en référence aux dessins annexés dans lesquels

- la figure 1 représente schématiquement un mode de réalisation du dispositif selon l'invention

- et la figure 2 représente en plan, à plus grande échelle, une pince du dispositif illustré par la figure 1.

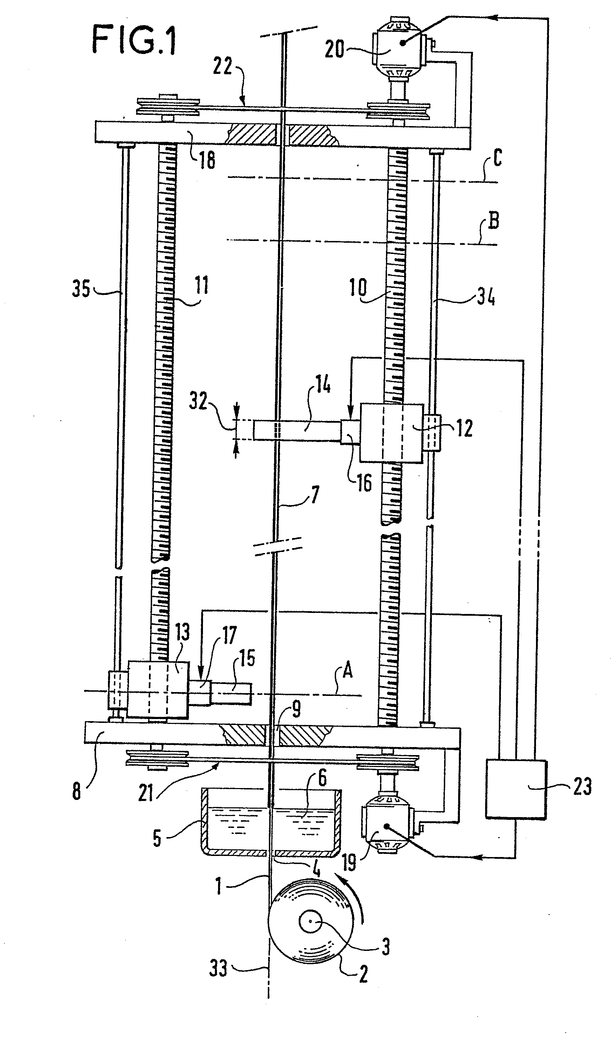

Sur la figure 1, est représenté un ruban de carbone 1 déroulé d'un tambour 2 monté en rotation autour d'un axe 3 perpendiculaire au plan de la figure 1. Le ruban 1, disposé dans un plan vertical 33 perpendiculaire au plan de la figure, traverse une fente 4 ménagée dans le fond d'un récipient 5 en quartz, contenant un bain 6 de silicium fondu. Les dimensions de la fente 4 sont choisies pour que le ménisque de raccordement entre le silicium liquide et les bords de la fente soit stable. Le ruban revêtu 7 sortant du bain 6 est couvert d'une couche de silicium polycristallin. Une plaque métallique horizontale 8, comportant une ouverture 9 pour laisser passer le ruban revêtu 7, est disposée au dessus du récipient 5. De part et d'autre des deux faces planes du ruban 7, sont fixées sur la plaque 8 respectivement deux tiges filetées verticales 10 et 11, montées en rotation autour de leurs axes. Sur chacune de ces tiges est fixé un chariot comportant un élément s'engrenant dans les filets de la tige de façon à permettre le déplacement du chariot le long de la tige lorsque celle-ci est entraînée en rotation autour de son axe. A chaque tige de fixation est associée une colonne cylindrique lisse, 34, 35 pour permettre le guidage du chariot au cours de son déplacement. Sur la figure 1, est représenté un chariot 12 situé sensiblement au milieu de la tige 10 et un chariot 13 situé en bas de la tige 11.

Sur chaque chariot est fixé une pince capable de saisir le ruban revêtu 7. Chaque pince comporte deux machoires mobiles dans un plan horizontal, articulées sur un support. C'est ainsi que la pince 14 fixée sur le chariot 12 est représentée fermée sur le ruban 7, tandis que la pince 15 fixée sur le chariot 13 est représentée ouverte. Aux pinces 14 et 15 sont associés respectivement deux systèmes électromécaniques 16 et 17 pour commander l'ouverture et la fermeture des machoires.

Une autre plaque métallique horizontale 18 est disposée à la partie supérieure du dispositif pour maintenir l'extrémité supérieure

0199093

des tiges 10 et 11. Deux moteurs électriques 19 et 20 sont fixés respectivement sur les plaques 8 et 18 pour entrainer en rotation les tiges 10 et 11 dans des sens différents et à des vitesses différentes. Des systèmes d'accouplement par poulies et courroies 21 et 22 sont prévus pour entrainer simultanément les deux tiges filetées 10 et 11. Le dispositif comporte en outre des embrayages non représentés pour permettre de désaccoupler les tiges filetées et les arbres des moteurs 19 et 20. Enfin un circuit de commande électrique 23 est relié aux moteurs 19 et 20 ainsi qu'aux systèmes électromécaniques 16 et 17.

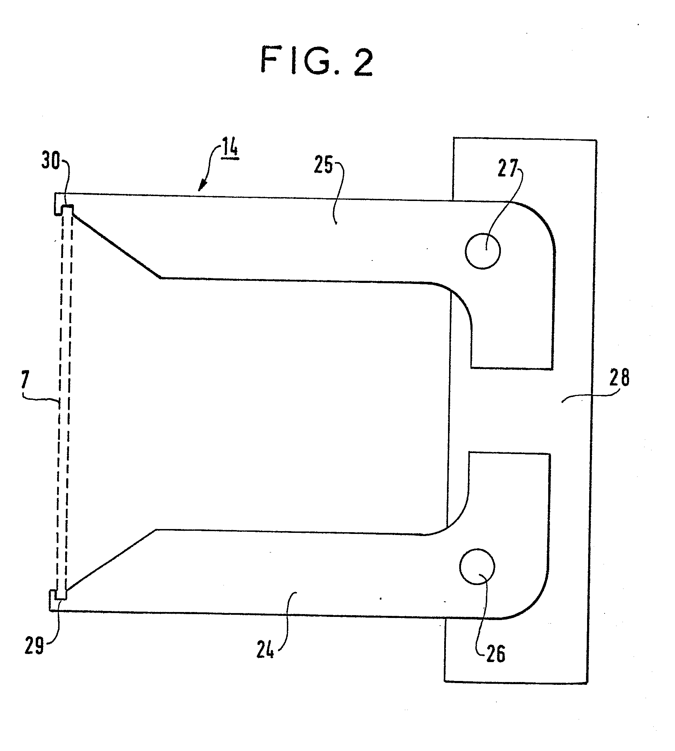

La figure 2 montre comment peuvent être réalisées les pinces du dispositif illustré par la figure 1. La pince 14, représentée en position fermée, comporte deux machoires 24 et 25 montées en rotation respectivement autour de deux axes parallèles 26 et 27. Ces axes sont fixés perpendiculairement sur un support 28 maintenu dans un plan horizontal, ce support étant monté sur le chariot 12 (figure 1). Les extrémités libres des deux machoires 24 et 25 sont munies respectivement de rainures verticales 29 et 30 dans lesquelles peuvent se loger les bords du ruban 7 dont la section est représentée en traits mixtes sur la figure 2.

Le dispositif décrit ci-dessus et illustré par les figures 1 et 2 fonctionne de la manière suivante.

Le chariot 13 restant immobile à son niveau le plus bas A en contact avec la plaque 8, les pinces 15 restant ouvertes, on met en marche le moteur 20 à l'aide du circuit 23 pour ramener le chariot 12 au niveau A. Puis on commande par le système 16 la fermeture des mâchoires de la pince 14 en guidant à la main le ruban 7 de façon que deux portions opposées de ses bords viennent se loger dans les rainures 29 et 30 des machoires 24 et 25.

Le tambour 2 est muni d'un système de freinage ou d'un ressort spirale, capable d'exercer en permanence sur le ruban un couple autour de l'axe 3, dirigé suivant la flèche 31, de façon à tendre le ruban 1-7 suivant un plan vertical 33 passant par l'axe de la fente 4. A titre indicatif, le ruban ayant une largeur de 5 cm et étant constitué par un support de carbone d'épaisseur comprise entre 200 et 300 micromètres, ce support étant recouvert sur ses deux faces d'une couche de silicium d'épaisseur 100 micromètres, la longueur 32 des portions des bords du ruban étant de un centimètre, la tension verticale appliquée au ruban est inférieure à 500 grammes.

Puis, on met en marche le moteur 19 pour provoquer un déplacement vertical continu du chariot 12 de bas en haut le long de la tige 10, à une vitesse prédéterminée qui correspond à la vitesse de tirage. La force de serrage de la pince 14 est réglée, compte tenu de la longueur 32 desdites portions, à une valeur suffisamment élevée pour empêcher tout glissement du ruban par rapport à la pince au cours de son déplacement. Cette force de serrage ne doit pas cependant être trop élevée afin d'éviter toute détérioration des bords du ruban et toute incurvation de ce ruban qui doit être maintenu sur toute sa surface dans le plan vertical 33.

Lorsque, au cours de son déplacement vertical, le chariot 12, dépassant la position représentée sur la figure 1, arrive à un niveau B légèrement inférieur au niveau maximum C, on commande par le circuit 23 la fermeture des pinces 15 sur les bords du ruban 7 et simultanément on commande l'entraînement en rotation de la tige 11 par le moteur 19 en utilisant le système d'accouplement 21. Le chariot 13 supportant la pince 15 fermée sur le ruban 7 se déplace donc vers le haut à la même vitesse que le chariot 12. Lorsque le chariot 12 atteint le niveau maximal C, on commande par le circuit 23 et le système 17 l'ouverture des pinces 14 de façon à lâcher le ruban 7. Simultanément on désaccouple le moteur 19 et la tige 10, et on accouple le moteur de descente 20 et la tige 10.

Le chariot 12 redescend vers la plaque 8, à une vitesse très supérieure à la vitesse de montée, tandis que le ruban 7, tiré par la pince 15, continue son mouvement vers le haut. Lorsque le chariot 12 est arrivé au niveau A, ses pinces 14 ouvertes sont prêtes à saisir le ruban ce qui sera réalisé dès que le chariot 13 arrivera au niveau B.

Bien entendu, il est possible de découper transversalement le ruban 7 au-dessus de la plaque 18 par des moyens connus non représentés, de façon à obtenir des feuilles revêtues de silicium, de longueur convenable. Ces feuilles peuvent être utilisées pour réaliser des photopiles solaires au silicium.

Le procédé et le dispositif décrits ci-dessus permettent d'assurer un tirage d'un ruban de carbone revêtu d'une couche de silicium polycristallin, à partir d'un bain de silicium fondu, suivant un axe de tirage très précis, sans déplacement latéral des bords du ruban dans le plan de tirage. Ce procédé diminue considérablement la probabilité de formation de fractures dans la couche du silicium. En effet de telles fractures ne peuvent se produire que dans les portions des bords du ruban serrées dans les pinces. Ces fractures ne peuvent donc concerner que les bords du ruban, dans des zones bien délimitées de faible longueur. En effet la longueur 32 des portions des bords du ruban serrées dans les pinces est toujours très faible par rapport à la distance entre le niveau inférieur A et le niveau supérieur C, le niveau B étant très proche du niveau C. A titre indicatif, la longueur 32 étant de l'ordre de un centimètre, la différence entre les niveaux C et A est de l'ordre de 50 centimètres. Il est à noter, de plus, que la couche de silicium déposée peut être renforcée en épaisseur sur les bords du ruban, ce qui augmente à cet endroit la résistance de cette couche à l'écrasement. Enfin, le serrage des pinces agit sur le ruban dans une direction transversale dans laquelle celui-ci présente une résistance à la flexion particulièrement grande, ce qui élimine toute possibilité d'incurvation du ruban au moment de sa préhension par les pinces.

Le procédé et le dispositif selon l'invention s'appliquent non seulement au tirage d'un ruban de carbone revêtu d'une couche de silicium à partir d'un bain de silicium fondu, en vue de la réalisation de photopiles solaires, mais aussi au tirage de rubans constitués par un support en un autre matériau que le carbone, ce support étant recouvert d'une couche d'un matériau semi-conducteur différent du silicium. A titre d'exemple le support peut être constitué par un matériau tel que le tungstène à très haut point fusion et le matériau semi-conducteur constituant la couche peut être le germanium, l'arséniure de gallium et le tellurure de cadmium. Le bain liquide du matériau semi-conducteur peut être constitué non seulement par du matériau fondu, mais aussi par une solution liquide de ce matériau.

0199093

REVENDICATIONS

1/ Procédé pour tirer un ruban constitué par un support revêtu d'une couche d'un matériau semi-conducteur à partir d'un bain liquide de ce matériau, le ruban étant tendu dans un plan vertical, caractérisé en ce qu'il comporte

- un serrage, entre les deux mâchoires d'une pince (14), de deux portions opposées des deux bords respectifs du ruban (7), le serrage étant effectué à un premier niveau (A), au-dessus du bain (6), de façon à saisir dans le plan vertical (33) le ruban (7) revêtu de ladite couche,

- et un déplacement vertical de la pince (14) serrant le ruban (7), ce déplacement s'effectuant à une vitesse constante prédéterminée, du premier niveau (A) à un deuxième niveau (C) supérieur au premier niveau (A), la distance entre les premier (A) et deuxième (C) niveaux étant grande par rapport à la longueur (32) desdites portions.

2/ Procédé selon la revendication 1, caractérisé en ce que, ladite pince (14) étant une première pince, il comporte en outre,

- un serrage, entre les deux mâchoires d'une deuxième pince (15) analogue à la première pince, de deux portions opposées des deux bords respectifs du ruban (7), ce serrage étant effectué au premier niveau (A) un peu avant la fin du déplacement de la première pince (14),

- un déplacement vertical de la deuxième pince (15) serrant le ruban (7), ce déplacement s'effectuant du premier niveau (A) au deuxième niveau (C) dès que le serrage de la deuxième pince (15) est réalisé, à une vitesse égale à ladite vitesse constante prédéterminée,

- une ouverture des mâchoires (24, 25) de la première pince (14) lorsqu'elle atteint le deuxième niveau (C), de façon à lâcher le ruban (7)

- et, juste après l'ouverture des mâchoires, un déplacement vertical de la première pince (14) du deuxième niveau (C) au premier niveau (A), ce déplacement s'effectuant à une vitesse supérieure à ladite vitesse constante prédéterminée, de manière que la première pince (14) soit prête à saisir le ruban (7) au premier niveau (A) avant que la deuxième pince (15) ne soit arrivée au deuxième niveau (C).

3/ Dispositif pour tirer un ruban constitué par un support revêtu d'une couche d'un matériau semi-conducteur, à partir d'un bain liquide de ce

- 8 -       0199093

matériau le ruban étant tendu dans un plan vertical, caractérisé en ce qu'il comporte

- deux colonnes verticales (34, 35) disposées de part et d'autre des faces planes du ruban (7),

- un chariot (12) fixé sur chaque colonne (34) de façon à pouvoir être déplacé verticalement le long de la colonne,

- une pince (14) fixée sur chaque chariot (12), cette pince (14) comprenant deux mâchoires articulées (24, 25) pour saisir le ruban (7) par ses bords, ces mâchoires étant munies de rainures (29, 30) dans lesquelles viennent se loger les bords du ruban (7),

- des moyens (16) pour commander l'ouverture et la fermeture des mâchoires desdites pinces (14)

- et des moyens (10, 19, 20, 23) pour commander le déplacement des chariots (12,13) au-dessus du bain (6) le long des colonnes (10, 11).

FIG.1

1/2

0199093

0199093

# FIG. 2

Office européen
des brevets

**RAPPORT DE RECHERCHE EUROPEENNE**

Ð199093
Numéro de la demande

EP  86 10 3771

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl 4) |
|---|---|---|---|
| A | FR-A-2 550 965  (C.G.E.) | | C 30 B  15/30 |
| | ----- | | |

DOMAINES TECHNIQUES RECHERCHES (Int. Cl 4)

C 30 B   15/00
C 30 B   15/30

Le présent rapport de recherche a été établi pour toutes les revendications

| Lieu de la recherche | Date d'achèvement de la recherche | Examinateur |
|---|---|---|
| LA HAYE | 23-07-1986 | BRACKE P.P.J.L. |